(19) Europäisches Patentamt / European Patent Office / Office européen des brevets

(11) **EP 2 088 674 B1**

(12) **FASCICULE DE BREVET EUROPEEN**

(45) Date de publication et mention de la délivrance du brevet:
**09.05.2018 Bulletin 2018/19**

(51) Int Cl.:
***H03K 17/082*** *(2006.01)*     ***G05F 1/573*** *(2006.01)*

(21) Numéro de dépôt: **09151440.6**

(22) Date de dépôt: **27.01.2009**

(54) **Système de commande et de protection d'un commutateur bas d'un équipement d'automatisme**

Regel und Schutzsystem für einen Low-Side Schalter einer Automatisierungseinrichtung

Control and protection system for a low-side switch of an automation equipment

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **08.02.2008 FR 0850795**

(43) Date de publication de la demande:
**12.08.2009 Bulletin 2009/33**

(73) Titulaire: **Schneider Electric Industries SAS
92500 Rueil-Malmaison (FR)**

(72) Inventeur: **Tonet, Richard
06650, LE ROURET (FR)**

(74) Mandataire: **Dufresne, Thierry et al
Schneider Electric Industries SAS
Service Propriété Industrielle
35 rue Joseph Monier
92500 Rueil-Malmaison (FR)**

(56) Documents cités:
| | |
|---|---|
| **EP-A- 0 252 541** | **EP-A- 0 860 946** |
| **EP-A2- 0 743 751** | **DE-A1- 3 445 031** |
| **DE-A1- 3 920 805** | **GB-A- 2 217 123** |
| **JP-A- H02 156 721** | **JP-A- H06 197 445** |
| **US-A- 4 750 079** | |

**Description**

La présente invention se rapporte à un système de commande et de protection électronique d'une voie de sortie d'un équipement d'automatisme, tel qu'un automate programmable industriel (ou PLC Programmable Logical Controller), en particulier une voie de sortie statique susceptible de piloter une charge électrique en fonction d'un signal numérique de commande issu de l'équipement d'automatisme.

Un automate programmable est un équipement d'automatisme capable de piloter, commander et/ou surveiller un ou plusieurs process, notamment dans le domaine des automatismes industriels, du bâtiment ou de la distribution électrique. Il comporte généralement une unité centrale et un certain de nombre de voies d'entrées et de voies de sorties. Lorsque l'automate programmable est de construction modulaire, ces entrées/sorties peuvent être groupées dans des modules d'entrées/ sorties comportant chacun par exemple 8, 16 ou 32 voies.

Les entrées permettent de recevoir des informations notamment en provenance de capteurs relatifs au process. L'unité centrale scrute d'abord les entrées, puis exécute un programme application (ou programme utilisateur) dans le but de piloter les sorties, lesquelles peuvent commander une charge électrique de type pré-actionneur, tel qu'une bobine d'excitation d'un appareil de commutation électromagnétique ou autres.

Les sorties statiques sont protégées contre les surcharges et les courts circuits par un système de protection électronique qui permet la disjonction de la sortie en cas de défaut. Généralement, la valeur du courant de disjonction est dimensionnée pour se déclencher à partir d'environ 1,25 fois la valeur du courant maximum spécifié, c'est-à-dire 125mA pour les sorties de courant nominal 100mA et 625mA pour les sorties 500mA.

Or, cette valeur de courant de disjonction peut s'avérer pénalisante dans certains cas, en particulier pour des voies de sorties commandant des pré-actionneurs de type charge capacitive ou lampe à filament. En effet, il est connu que dans le cas d'une lampe à filament par exemple, la résistance de la lampe varie beaucoup en fonction de la température du filament, ce qui entraîne une forte variation du courant qui traverse la lampe en fonction de la température du filament. Lorsque la température du filament est basse, par exemple à température ambiante au moment de l'allumage, la résistance du filament est faible et le courant qui traverse la lampe est donc très élevé. La température du filament augmente ensuite rapidement et se stabilise, ce qui augmente rapidement sa résistance et ce qui diminue donc le courant.

Ainsi, on considère que la valeur initiale du courant de pointe susceptible de traverser la lampe pendant cette phase de démarrage peut ainsi atteindre cinq fois le courant nominal (par exemple 500 mA pour une sortie 24Vdc de courant nominal 100mA) et que le courant circulant dans la lampe ne se stabilise à sa valeur nominale qu'après environ 10ms. Un tel comportement peut aussi se rencontrer au démarrage pour des charges capacitives. Il est alors évident qu'un système classique de protection d'une voie de sortie déclenchera alors sur disjonction.

Le document US4,750,079 décrit déjà un circuit de commande et de protection d'un transistor MOS destiné à commander une charge. Cependant, ce circuit ne mesure pas directement le courant circulant dans la charge, ne comporte pas de dispositif de limitation de la tension circulant dans la charge et ne comporte pas de dispositif de disjonction permettant de bloquer le transistor MOS lorsque le courant dépasse un seuil prédéterminé pendant une durée prédéfinie. Le document JP H06 197445 A décrit déjà un circuit de limitation de courant alternatif.

L'invention a donc pour but d'éviter une disjonction intempestive d'une voie de sortie statique à transistor pendant cette phase de démarrage et de stabilisation du courant, tout en garantissant son immunité à la puissance engendrée par l'augmentation du courant qui la traverse et donc sa dégradation, voire sa destruction.

L'invention a également pour but de limiter le courant de pointe durant le temps de stabilisation, de façon à éviter ainsi la nécessité de surdimensionner l'organe de commutation statique de la sortie (tel qu'un transistor) pour pouvoir absorber le courant de pointe initial au démarrage. Avantageusement, l'invention permet de commander et protéger des sorties de façon autonome, sans nécessiter un dispositif supplémentaire de disjonction thermique par exemple.

Pour cela, l'invention décrit un système de commande et de protection d'une voie de sortie d'un équipement d'automatisme destinée à piloter une charge électrique en fonction d'un signal de commande issu de l'équipement d'automatisme selon la revendication indépendante. Le système comporte un dispositif de commutation comprenant une résistance de charge et un transistor MOS de commutation commutable à l'aide du signal de commande entre un état passant dans lequel la charge est alimentée en série avec la résistance de charge et un état bloqué, un dispositif de limitation limitant la tension aux bornes de la résistance de charge à une valeur maximale prédéterminée, et un dispositif de disjonction de la voie de sortie capable de commuter le transistor de commutation à l'état bloqué lorsque le courant traversant la résistance de charge dépasse un seuil prédéterminé pendant une durée prédéfinie.

Selon l'invention, la résistance de charge est reliée entre la source du transistor de commutation et une borne de tension négative, la charge électrique est reliée entre le drain du transistor de commutation et une source de tension positive, la charge n'étant pas commandée quand le transistor de commutation est à l'état bloqué.

Selon l'invention, le dispositif de limitation comporte un élément de chute de tension agencé pour que la valeur maximale de la tension aux bornes de la résistance de charge soit limitée par une chute de tension prédéterminée aux bornes de l'élément.

Selon l'invention, le dispositif de disjonction comprend un module comparateur permettant de comparer la tension aux bornes de la résistance de charge avec une tension de référence, un module temporisateur dont l'entrée est reliée à la sortie du module comparateur, et un transistor MOS de disjonction dont la grille est reliée à la sortie du module temporisateur.

Selon un mode de réalisation, l'élément de chute de tension comporte deux diodes en série dont les cathodes sont placées du côté de la borne de tension négative. Alternativement l'élément de chute de tension comporte une diode Zener dont la cathode est placée du côté de la borne de tension négative.

Selon un mode alternatif, l'élément de chute de tension comporte un transistor bipolaire dont la base est reliée à la source du transistor de commutation, dont l'émetteur est relié à la borne de tension négative et dont le collecteur est relié à la grille du transistor de commutation, la chute de tension aux bornes de l'élément étant prédéterminée par la tension base-émetteur dudit transistor bipolaire.

L'invention concerne également un équipement d'automatisme comprenant une unité centrale et au moins une voie de sortie dans le but de commander une charge électrique, l'unité centrale étant susceptible de générer un signal de commande durant l'exécution d'un programme de commande et/ou de surveillance pour commuter ladite voie de sortie, l'équipement d'automatisme comportant un tel système de commande et de protection de ladite voie de sortie.

D'autres caractéristiques et avantages vont apparaître dans la description détaillée qui suit en se référant à un mode de réalisation donné à titre d'exemple et représenté par les dessins annexés sur lesquels :

- la figure 1 représente un schéma simplifié d'un premier mode de réalisation d'un système de commande et de protection électronique d'une voie de sortie conforme à l'invention,
- la figure 2 montre un schéma alternatif à l'invention.

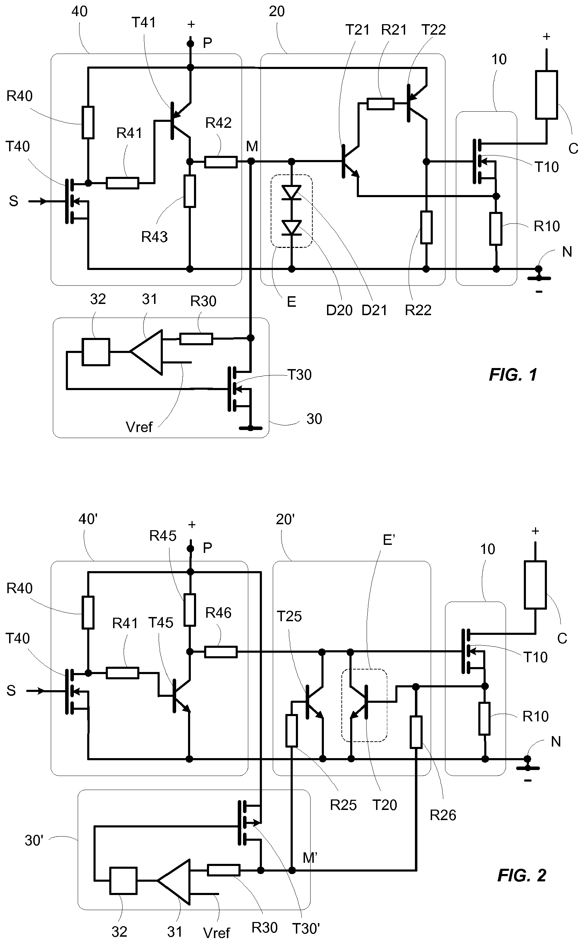

En référence aux figures 1 et 2, une charge électrique extérieure C est susceptible d'être commandée à partir d'un signal numérique de commande S provenant d'une voie de sortie d'un équipement d'automatisme tel qu'un automate programmable. Le signal de commande S est généré par l'unité centrale de l'automate programmable suite par exemple à l'exécution d'un programme application. A partir de ce signal de commande S, un système de commande et de protection électronique est destiné à piloter le circuit électronique de sortie et à le protéger contre un défaut de surcharge et/ou de court-circuit de la charge C.

Dans le mode de réalisation présenté en figure 1, le système de commande et de protection électronique comporte un dispositif de commande 40 sur lequel arrive le signal de commande S, un dispositif de commutation statique 10 permettant de commander la charge électrique C, un dispositif de limitation 20 permettant de limiter le courant circulant dans le dispositif de commutation statique 10 et un dispositif de disjonction 30 permettant en cas de défaut de couper la commande du dispositif de commutation statique 10.

Le dispositif de commutation 10 comporte une résistance de charge R10 et un transistor de commutation T10 de type MOSFET canal N. La charge électrique C est connectée entre une source de tension positive, telle qu'une tension pré-actionneur 24 Vdc, et le drain du transistor de commutation T10. La résistance de charge R10 est connectée entre une borne de tension négative N (correspondant à la masse ou à un point 0 de tension - tension nulle) et la source du transistor de commutation T10. Ainsi, lorsque le transistor de commutation T10 est à l'état passant, la charge C et la résistance de charge R10 sont alimentées en série entre la source de tension positive et la borne négative N. Lorsque le transistor de commutation T10 est à l'état bloqué, la charge C n'est pas alimentée.

Le dispositif de limitation 20 a pour fonction de limiter la tension aux bornes de la résistance de charge R10 à une valeur maximale prédéterminée, de façon à limiter le courant maximum traversant la résistance R10 et donc le courant traversant le transistor de commutation T10. Il comporte principalement un transistor bipolaire NPN T21, un transistor bipolaire PNP T22 et un élément E de chute de tension.

L'émetteur du transistor T22 est relié à une borne positive de tension P. Le collecteur du transistor T22 est relié à la borne négative N via une résistance R23 et est également relié à la grille du transistor de commutation T10. La base du transistor T22 est reliée au collecteur du transistor T21 via une résistance R22. L'émetteur du transistor T21 est relié à la source du transistor de commutation T10. La base du transistor T21 est reliée au signal de sortie du dispositif de commande 40. La base du transistor T21 forme un point M qui est relié à la borne de tension négative N à travers l'élément E de chute de tension. Le point M correspond au point de mesure de tension utilisé dans le dispositif de disjonction 30. Entre la borne positive P et la borne négative N, il existe une tension V égale par exemple à 5Vdc et qui peut être générée à partir de la tension pré-actionneur (par exemple 24vdc).

Dans le mode de réalisation, l'élément E de chute de tension est composé de deux diodes D20 et D21 reliées en série entre le point M et la borne négative N. Les anodes des diodes D20 et D21 sont dirigées vers le point M et les cathodes vers la borne négative N.

Le dispositif de disjonction 30 comporte un transistor de disjonction T30 de type MOS canal N dont le drain est relié au point M et dont la source est reliée à la borne négative N. Le dispositif de disjonction 30 comporte également un module comparateur 31 et un module temporisateur 32. Le module comparateur 31 possède une première entrée reliée au point M via une résistance R30 et une seconde entrée recevant une tension de référence $V_{ref}$. La sortie du module comparateur 31 est reliée à l'entrée du module temporisateur 32 et la sortie du module temporisateur 32 est reliée à la grille du transistor T30. Le module comparateur 31 sert donc à comparer la tension au point M (et donc indirectement la tension aux bornes de la résistance de charge R10) avec la tension de référence $V_{ref}$.

Par ailleurs, le dispositif de commande 40 comporte un transistor T40 de type MOS canal N. La grille du transistor T40 est reliée au signal de commande S. La source du transistor T40 est reliée à la borne négative N du circuit électronique. Le drain du transistor T40 est relié d'une part à la base d'un transistor bipolaire PNP T41 via une résistance R41 et d'autre part à la borne positive P via une résistance R40. La valeur de la résistance R41 est de préférence élevée pour que le courant de chute de R41 soit négligeable. L'émetteur du transistor T41 est relié à la borne positive P et le collecteur du transistor T41 est relié d'une part à la borne négative N via une résistance R43 et d'autre part au point M via une résistance R42.

Le fonctionnement normal du système de commande et de protection est le suivant :

- Quand le signal de commande S est égal à 0, le transistor T40 est à l'état bloqué (ouvert). La base du transistor T41 est rappelée à la borne positive P via R41 et R40 et le transistor T41 est donc également bloqué. La base du transistor T21 est alors rappelée à la borne négative N via R42 et R43, et le transistor T21 est bloqué. Ceci a pour conséquence que la base du transistor T22 est à l'état 1, donc T22 est bloqué. Dans ce cas, la grille de T10 est rappelée à la borne N via R22 et donc le transistor de commutation T10 est bloqué et la charge C n'est pas commandée.

- Quand le signal de commande S passe à 1, le transistor T40 devient passant (fermé). La base du transistor T41 est rappelée à la borne N via R41 et le transistor T41 devient également passant. La base du transistor T21 est alors rappelée à la borne positive P via R42, et le transistor T21 devient passant. Ceci a pour conséquence que la base du transistor T22 est rappelée à la borne N via R21 et R10, donc T22 est passant. Dans ce cas, la grille de T10 est rappelée à la borne positive P et donc le transistor de commutation T10 est passant et la charge C est commandée.

La chute de tension $V_E$ aux bornes de l'élément E est égale à : $V_E = V_{R10} + V_{BET21}$ dans lequel $V_{R10}$ représente la tension aux bornes de la résistance R10 et $V_{BET21}$ représente la tension Base-Emetteur du transistor T21. Selon l'invention, l'élément de chute de tension E est choisi pour fournir une chute de tension $V_E$ déterminée et stable afin de pouvoir limiter dans tous les cas la tension $V_{R10}$ à une valeur maximum égale à $V_{R10max}$ lorsque la sortie est commandée (charge C alimentée). Or, quand le transistor T21 est passant et saturé, c'est-à-dire quand la sortie est commandée, la chute de tension $V_{BET21}$ entre Base et Emetteur de T21 est fixe et égale à environ 0,6 V.

Dans le mode de réalisation de la figure 1, l'élément E est composé des deux diodes D20 et D21 qui fournissent chacune une chute de tension $V_{D20}$ et $V_{D21}$ constante égale à environ 0,6 V, ce qui correspond à une valeur usuelle pour ce genre de composant. La chute de tension $V_E$ aux bornes de l'élément E est donc prédéterminée et égale à $V_{D20}$ + $V_{D21}$. On obtient donc une limitation de la valeur de la tension $V_{R10}$ :

$$V_{R10max} = V_E - V_{BET21} = V_{D20} + V_{D21} - 0,6\ V0 = V_{D20} = 0,6\ V$$

Le courant maximal circulant dans la résistance de charge R10 est égal à :

$$I_{R10max} = V_{R10max} / R10 = V_{D20} / R10.$$

Comme $V_{D20}$ et R10 sont déterminés, on peut ainsi pendant un certain temps limiter le courant $I_{R10}$ traversant R10 et donc le courant traversant le transistor de commutation T10, même en cas de court-circuit. Le transistor T10 n'a ainsi pas besoin d'être dimensionné de façon trop importante, ce qui constitue un gros avantage en terme de dissipation thermique et d'implantation de la voie de sortie dans un module d'entrées/sorties de l'automate programmable, pour pouvoir installer par exemple 32 voies de sortie sur un seul module, chaque voie étant équipé d'un système de commande et de protection électronique conforme à l'invention.

En effet, lorsque la charge C est en court-circuit, alors la tension $V_{DST10}$ entre la source et le drain du transistor T10 est sensiblement égale à : $V_{DST10} = 24 - V_{R10max}$, dans le cas où la tension positive est 24 Vdc. Le transistor T10 doit alors juste être capable de supporter la puissance $P_{max}$ suivante pendant la durée de la temporisation, à savoir : $P_{max} = V_{DST10} * I_{R10max}$, c'est-à-dire : $P_{max} = (24 - V_{R10max}) * V_{D20} / R10$.

Lorsque la voie de sortie fonctionne normalement et n'est pas en court-circuit, le point M est au potentiel $V_{M1}$ qui est égal à $V_{M1} = V_{BET21} + V_{R10}$, dans lequel $V_{R10}$ a une valeur faible, car le courant consommé par la charge C est le courant nominal. Par contre, lorsque la sortie est en court-circuit, le point M est alors au potentiel $V_{M2}$ égal à $V_{M2}$ = $V_{BET21}$ + $V_{R10max}$, avec $V_{R10max}$ = $V_{D20}$ = 0,6 V.

Le point M est connecté à la première entrée du module comparateur 31, via la résistance R30. Il n'est pas utile de prendre en compte la résistance R30 car la valeur de cette résistance R30 est très faible et l'impédance d'entrée du comparateur 31 est très grande. Une tension de référence $V_{ref}$ est appliquée sur la seconde entrée du comparateur 31. Cette tension de référence $V_{ref}$ est choisie entre les valeurs $V_{M1}$ et $V_{M2}$, de façon à ce que le module comparateur 31 puisse détecter un court-circuit de la sortie. Ainsi, en fonctionnement normal, la valeur $V_{M1}$ est inférieure à la tension de référence $V_{ref}$ et la sortie du comparateur vaut zéro. En cas de court-circuit, la valeur $V_{M2}$ devient supérieure à $V_{ref}$ et la sortie du comparateur vaut 1. Pour augmenter la précision du seuil de disjonction et la rendre indépendante de la température, la tension de référence $V_{ref}$ est de préférence réalisée à l'aide d'une tension Base-Emetteur d'un autre transistor bipolaire appairé au transistor T21. Ainsi, le module comparateur 31 permet donc de comparer la tension aux bornes de la résistance de charge R10 avec la tension de référence $V_{ref}$.

Lorsqu'elle est à 1, la sortie du module comparateur 31 enclenche alors le module temporisateur 32, dont la durée est prédéfinie pour être capable de laisser passer les court-circuits temporaires pouvant survenir au démarrage de certaines sorties, par exemple de l'ordre de 10 ms. Si le court-circuit est toujours présent en fin de temporisation, alors le module temporisateur 32 bascule et la grille du transistor T30 est commandée, ce qui a pour effet de relier directement le point M avec la borne négative N. La base de T21 est alors rappelée à la borne négative N ce qui a pour effet de bloquer le transistor T21 et donc de passer le transistor T10 à l'état bloqué. La charge C n'est plus commandée.

Ainsi, en cas de surcharge ou de court-circuit, le système de commande et de protection est capable de couper la sortie au bout de la durée prédéfinie dans le module temporisateur 32, en cas de dépassement de la tension aux bornes de la résistance de charge R10 au-delà d'un seuil prédéterminé par la tension de référence $V_{ref}$. De plus, pendant cette durée prédéfinie, le système est capable de limiter le courant traversant le transistor de commutation T10 et la résistance de charge R10 à un courant maximal $I_{R10max}$ calculé à partir de la chute de tension de l'élément E.

On pourrait aussi remplacer l'ensemble des deux diodes D20 et D21 de l'élément E par une seule diode Zéner dont la cathode serait placée du côté de la borne N, et ayant une chute de tension égale par exemple à environ 1,3 V, bien que la chute de tension fournie par une Zéner soit moins précise.

La figure 2 présente un mode alternatif à l'invention. Dans ce mode, le système de commande et de protection électronique comporte un dispositif de commande 40' sur lequel arrive le signal de commande S, un dispositif de commutation statique 10 permettant de commander la charge électrique C, un dispositif de limitation 20' permettant de limiter le courant circulant dans le dispositif de commutation statique 10 et un dispositif de disjonction 30' permettant en cas de défaut de couper la commande du dispositif de commutation statique 10. Le dispositif de commutation 10 est identique à celui décrit pour la figure 1.

Le dispositif de limitation 20' a pour fonction de limiter la tension aux bornes de la résistance de charge R10 à une valeur maximale prédéterminée, de façon à limiter le courant maximum traversant la résistance R10 et donc le courant traversant le transistor de commutation T10. Il comporte principalement un transistor bipolaire NPN T25 et un élément E' de chute de tension.

L'émetteur du transistor T25 est relié à la borne de tension négative N. Le collecteur du transistor T25 est relié à la grille du transistor de commutation T10. La base du transistor T25 est reliée à un point de mesure M' via une résistance R25. Le point M' est également relié à la source du transistor T10 à travers une résistance R26 de très grande valeur. Le point M' correspond au point de mesure de tension utilisé dans le dispositif de disjonction 30'. La grille du transistor T10 est reliée au signal de sortie du dispositif de commande 40'.

Dans le mode de la figure 2, l'élément de chute de tension E' est composé d'un transistor bipolaire NPN T20 qui est monté tête-bêche avec le transistor T25. Ainsi, l'émetteur du transistor T20 est relié à l'émetteur du transistor T25, de même que le collecteur du transistor T20 est relié au collecteur du transistor T25. La base du transistor T20 est reliée à la source du transistor T10. La chute de tension $V_{E'}$ entre la base et l'émetteur du transistor T20 de l'élément E' est donc égale à : $V_{E'}$ = $V_{R10}$.

Le dispositif de disjonction 30' comporte un transistor de disjonction T30' de type MOS canal P dont le drain est relié au point M' et dont la source est reliée à la borne positive P. Le dispositif de disjonction 30' comporte également un module comparateur 31 et un module temporisateur 32. Le module comparateur 31 possède une première entrée à forte impédance qui est reliée au point M' via une résistance R30 et une seconde entrée recevant une tension de référence $V_{ref}$. La sortie du module comparateur 31 est reliée à l'entrée du module temporisateur 32 et la sortie du module temporisateur 32 est reliée à la grille du transistor T30'. Le module comparateur 31 sert donc à comparer la tension au point M' avec la tension de référence $V_{ref}$.

Par ailleurs, le dispositif de commande 40' comporte un transistor T40 de type MOS canal N. La grille du transistor T40 est reliée au signal de commande S. La source du transistor T40 est reliée à la borne négative N. Le drain du transistor T40 est relié d'une part à la base d'un transistor bipolaire NPN T45 via une résistance R41 et d'autre part à la borne positive P via une résistance R40. La valeur de la résistance R41 est très élevée pour que le courant de chute de R41 soit négligeable. L'émetteur du transistor T45 est relié à la borne négative N. Le collecteur du transistor T45 est relié d'une part à la borne positive P via une résistance R45 et d'autre part à la grille du transistor T10 via une résistance R46.

Le fonctionnement normal du système de commande et de protection est le suivant :

- Quand le signal de commande S est égal à 0, le transistor T40 est à l'état bloqué (ouvert). La base du transistor T45 est rappelée à la borne positive P via R41 et R40 et le transistor T45 est donc passant. Dans ce cas, la grille du transistor T10 est rappelée à la borne négative N via la résistance R46, donc le transistor de commutation T10 est bloqué et la charge C n'est pas commandée.
- Quand le signal de commande S passe à 1, le transistor T40 devient passant (fermé). La base du transistor T45 est rappelée à la borne N via R41 et le transistor T45 devient bloqué. Dans ce cas, la grille du transistor T10 est rappelée à la borne positive P via les résistances R45 et R46, donc le transistor de commutation T10 est passant et la charge C est commandée.

La tension maximale $V_{R10max}$ aux bornes de la résistance R10 est limitée par la tension Base-Emetteur $V_{BET20}$ du transistor T20, qui est fixe et par exemple de l'ordre de 0,6V. On obtient donc une limitation de la valeur de la tension $V_{R10}$ :

$$V_{R10max} = V_{BET20} = 0,6 \ V$$

Donc, le courant maximal circulant dans la résistance R10 est égal à : $I_{R10max} = V_{R10max} / R10 = V_{BET20} / R10$, dans lequel $V_{BET20}$ et R10 sont déterminés. Ainsi, comme dans le mode de réalisation selon l'invention, on peut pendant un certain temps limiter le courant $I_{R10}$ traversant R10 et donc limiter le courant traversant le transistor de commutation T10, même en cas de court-circuit.

A titre d'exemple, pour des sorties alimentées par une source de tension 24 Vdc à courant nominal égal à 500 mA, on peut choisir une résistance R10 égale à 0,33 Ohms (0R33), ce qui donne un courant $I_{R10max}$ égal à 1,8 A. Pour des sorties 100 mA, la résistance R10 peut être égale à 2,2R Ohms.

Le point M' est au potentiel suivant $V_{M'} = V_{R10} + V_{R26}$. En réalité, R26 a une valeur élevée car sa fonction est la transmission de la tension aux bornes de R10 et quand le transistor T30' devient passant il ne faut pas que T30' génère un courant dans la résistance R10 et on peut donc négliger la tension à ses bornes. Lorsque la charge C est commandée normalement et n'est pas en court-circuit, le point M' est au potentiel suivant $V_{M'1} = V_{R10}$, dans lequel $V_{R10}$ a une valeur relativement faible, car le courant consommé par la charge est le courant nominal. Par contre, lorsque la sortie est en court-circuit, le point M' est alors au potentiel suivant $V_{M'2} = V_{R10max}$, avec $V_{R10max} = V_{BET20} = 0,6 \ V$.

Ainsi, comme dans le premier mode de réalisation, le module comparateur 31 permet de comparer la tension aux bornes de la résistance de charge R10 (point M' relié à la première entrée du comparateur 31) avec la tension de référence $V_{ref}$ appliquée sur la seconde entrée du comparateur 31. Cette tension de référence $V_{ref}$ est choisie entre les valeurs $V_{M'1}$ et $V_{M'2}$, de façon à ce que le module comparateur 31 puisse détecter un court-circuit de la sortie. Ainsi, en fonctionnement normal, la valeur $V_{M'1}$ est inférieure à la tension de référence $V_{ref}$ et la sortie du comparateur vaut zéro. En cas de court-circuit, la valeur $V_{M'2}$ devient supérieure à $V_{ref}$ et la sortie du comparateur vaut 1.

La sortie du module comparateur 31 enclenche alors le module temporisateur 32, dont la durée est prédéfinie pour être capable de laisser passer les court-circuits temporaires pouvant survenir au démarrage de certaines sorties, par exemple de l'ordre de 10 ms. Si le court-circuit est toujours présent en fin de temporisation, alors le module temporisateur 32 bascule et la grille du transistor T30' est commandée, ce qui a pour effet de relier directement le point M' avec la borne positive P. La base du transistor T25 est donc reliée à la borne positive P et le transistor T25 devient passant. Ceci a pour effet de rappeler la grille du transistor de commutation T10 à la borne négative N et donc de bloquer le transistor de commutation T10. La charge C n'est alors plus commandée.

Ainsi, en cas de surcharge ou de court-circuit, le système de protection est capable de couper la sortie au bout de la durée prédéfinie dans le module temporisateur 32, en cas de dépassement de la tension aux bornes de la résistance de charge R10 au-delà d'un seuil prédéterminé par la tension de référence $V_{ref}$. De plus, pendant cette durée prédéfinie, le système de protection est capable de limiter le courant traversant le transistor de commutation T10 et la résistance de charge R10 à un courant maximal $I_{R10max}$ calculé à partir de la chute de tension de l'élément E'.

Avantageusement, un système de commande et de protection d'une voie de sortie tel que décrit précédemment peut être intégré dans un même circuit intégré. De même, plusieurs systèmes de commande et de protection des voies de sorties d'un module d'entrées/sorties peuvent être intégrés dans un même circuit intégré.

### Revendications

1. Système de commande et de protection d'une voie de sortie d'un équipement d'automatisme destinée à piloter une charge électrique (C) en fonction d'un signal de commande (S) issu de l'équipement d'automatisme, le système comportant un dispositif de commutation (10) qui comprend une résistance de charge (R10) et un transistor MOS de commutation (T10) commutable à l'aide du signal de commande (S) entre un état passant dans lequel la charge (C) est alimentée en série avec la résistance de charge (R10) et un état bloqué, la résistance de charge (R10) étant reliée entre la source du transistor de commutation (T10) et une borne de tension négative (N), le système comportant :

   - un dispositif de limitation (20) qui limite la tension aux bornes de la résistance de charge (R10) à une valeur maximale prédéterminée ($V_{R10max}$), **caractérisé en ce que** le système comporte en outre :

      - un dispositif de disjonction (30, 30') de la voie de sortie capable de commuter, à l'aide d'un transistor de disjonction (T30), le transistor de commutation (T10) à l'état bloqué lorsque le courant traversant la résistance de charge (R10) dépasse un seuil prédéterminé pendant une durée prédéfinie, le dispositif de disjonction (30, 30') comprenant un module comparateur (31) qui permet de comparer la tension aux bornes de la résistance de charge (R10) avec une tension de référence ($V_{ref}$),

   et **caractérisé en ce que** :

      - le dispositif de limitation (20) comporte un élément de chute de tension (E) agencé pour que la valeur maximale ($V_{R10max}$) de la tension aux bornes de la résistance de charge (R10) soit limitée par une chute de tension prédéterminée aux bornes de l'élément (E),
      - le dispositif de limitation (20) comporte un transistor bipolaire (T21) dont l'émetteur est relié à la source du transistor de commutation (T10), l'élément de chute de tension (E) étant relié entre la borne de tension négative (N) et la base dudit transistor bipolaire (T21), le drain du transistor de disjonction (T30) étant relié à la base du transistor bipolaire (T21) et la source du transistor de disjonction (T30) étant reliée à la borne négative (N).

2. Système de commande et de protection selon la revendication 1, dans lequel la charge électrique (C) est reliée entre le drain du transistor de commutation (T10) et une source de tension positive, la charge (C) n'étant pas commandée quand le transistor de commutation (T10) est à l'état bloqué.

3. Système de commande et de protection selon la revendication 1, dans lequel le dispositif de disjonction (30, 30') comprend un module temporisateur (32) dont l'entrée est reliée à la sortie du module comparateur (31), et le transistor de disjonction (R30, T30') est un transistor MOS de disjonction (T30, T30') dont la grille est reliée à la sortie du module temporisateur (32).

4. Système de commande et de protection selon la revendication 1, dans lequel l'élément de chute de tension (E) comporte deux diodes (D20, D21) en série dont les cathodes sont placées du côté de la borne de tension négative (N).

5. Système de commande et de protection selon la revendication 1, dans lequel l'élément de chute de tension (E) comporte une diode Zener dont la cathode est placée du côté de la borne de tension négative (N).

6. Equipement d'automatisme comprenant une unité centrale et au moins une voie de sortie destinée à commander une charge électrique (C), l'unité centrale étant susceptible de générer un signal de commande (S) durant l'exécution d'un programme de commande et/ou de surveillance pour commuter ladite voie de sortie, l'équipement d'automatisme comportant un système de commande et de protection électronique de ladite voie de sortie selon l'une des revendications précédentes.

### Patentansprüche

1. Regel- und Schutzsystem für einen Ausgangskanal einer Automatisierungseinrichtung, der dazu bestimmt ist, eine elektrische Ladung (C) in Abhängigkeit von einem Steuersignal (S), das von der Automatisierungseinrichtung kommt, zu steuern, wobei das System eine Schaltvorrichtung (10) umfasst, die einen Ladewiderstand (R10) und einen MOS-Schalttransistor (T10) umfasst, der mit Hilfe des Steuersignals (S) zwischen einem durchgeschalteten Zustand, in dem die Ladung (C) in Serie mit dem Ladewiderstand (R10) versorgt wird, und einem gesperrten Zustand umschaltbar ist, wobei der Ladewiderstand (R10) zwischen der Source des Schalttransistors (T10) und einer negativen Spannungsklemme (N) angeschlossen ist, wobei das System umfasst:

- eine Begrenzungsvorrichtung (20), die die Spannung an den Klemmen des Ladewiderstands (R10) auf einen vorbestimmten Maximalwert ($V_{R10max}$) begrenzt, **dadurch gekennzeichnet, dass** das System ferner umfasst:
- eine Sperrvorrichtung (30, 30') des Ausgangskanals, die geeignet ist, mit Hilfe eines Sperrtransistors (T30) den Schalttransistor (T10) in den gesperrten Zustand umzuschalten, wenn der den Ladewiderstand (R10) durchquerende Strom eine vorbestimmte Grenze während einer vordefinierten Dauer überschreitet, wobei die Sperrvorrichtung (30, 30') ein Vergleichsmodul (31) umfasst, das es ermöglicht, die Spannung an den Klemmen des Ladewiderstands (R10) mit einer Referenzspannung ($V_{ref}$) zu vergleichen,

und **dadurch gekennzeichnet, dass**:

- die Begrenzungsvorrichtung (20) ein Spannungsabsenkelement (E) umfasst, das derart vorgesehen ist, dass der Maximalwert ($V_{R10max}$) der Spannung an den Klemmen des Ladewiderstands (R10) durch eine vorbestimmte Spannungsabsenkung an den Klemmen des Elements (E) begrenzt wird,
- die Begrenzungsvorrichtung (20) einen bipolaren Transistor (T21) umfasst, dessen Sender mit der Source des Schalttransistors (T10) verbunden ist, wobei das Spannungsabsenkelement (E) zwischen der negativen Spannungsklemme (N) und der Basis des bipolaren Transistors (T21) angeschlossen ist, wobei der Drain des Sperrtransistors (T30) an der Basis des bipolaren Transistors (T21) angeschlossen ist, und die Source des Sperrtransistors (T30) an der negativen Klemme (N) angeschlossen ist.

2. Regel- und Schutzsystem nach Anspruch 1, bei dem die elektrische Ladung (C) zwischen dem Drain des Schalttransistors (T10) und einer positiven Spannungsquelle angeschlossen ist, wobei die Ladung (C) nicht gesteuert wird, wenn sich der Schalttransistor (T10) im gesperrten Zustand befindet.

3. Regel- und Schutzsystem nach Anspruch 1, bei dem die Sperrvorrichtung (30, 30') ein Verzögerungsmodul (32) umfasst, dessen Eingang mit dem Ausgang des Vergleichsmoduls (31) verbunden ist, und der Sperrtransistor (T30, T30') ein MOS-Sperrtransistor (T30, T30') ist, dessen Gate mit dem Ausgang des Verzögerungsmoduls (32) verbunden ist.

4. Regel- und Schutzsystem nach Anspruch 1, bei dem das Spannungsabsenkelement (E) zwei Dioden (D20, D21) in Serie umfasst, deren Kathoden auf der Seite der negativen Spannungsklemme (N) angeordnet sind.

5. Regel- und Schutzsystem nach Anspruch 1, bei dem das Spannungsabsenkelement (E) eine Zener-Diode umfasst, deren Kathode auf der Seite der negativen Spannungsklemme (N) angeordnet ist.

6. Automatisierungseinrichtung, umfassend eine Zentraleinheit und mindestens einen Ausgangskanal, der dazu bestimmt ist, eine elektrische Ladung (C) zu steuern, wobei die Zentraleinheit geeignet ist, ein Steuersignal (S) während der Ausführung eines Regel- und/oder Überwachungsprogramms zu erzeugen, um den Ausgangskanal umzuschalten, wobei die Automatisierungseinrichtung ein elektronisches Regel- und Schutzsystem des Ausgangskanals nach einem der vorhergehenden Ansprüche umfasst.

**Claims**

1. Control and protection system for automation equipment output channel which is capable to drive an electric load (C) according to a control signal (S) originating from the automation equipment, the system comprising a switching device (10) which comprises a load resistor (R10) and a switching MOS transistor (T10) that can be switched by the control signal (S) between an on state in which the load (C) is supplied in series with the load resistor (R10) and an off state, the load resistor (R10) being connected between the source of the switching transistor (T10) and a negative voltage terminal (N), the system comprising:

- a limitation device (20) which limits the voltage at the terminals of the load resistor (R10) to a predetermined maximum value ($V_{R10max}$), **characterized in that** the system also comprises:
- a tripping device (30, 30') for the output channel, capable of switching the switching transistor (T10), with the help of a tripping transistor (T30), to the off state when the current passing through the load resistor (R10) exceeds a predetermined threshold for a predefined time, the tripping device (30, 30') comprising a comparator module (31) which makes it possible to compare the voltage at the terminals of the load resistor (R10) with a reference voltage ($V_{ref}$),

and **characterized in that**:

- the limitation device (20) comprises a voltage drop element (E) designed so that the maximum value ($V_{R10max}$) of the voltage at the terminals of the load resistor (R10) is limited by a predetermined voltage drop at the terminals of the element (E),
- the limitation device (20) comprises a bipolar transistor (T21), the emitter of which is connected to the source of the switching transistor (T10), the voltage drop element (E) being connected between the negative voltage terminal (N) and the base of said bipolar transistor (T21), the drain of the tripping transistor (T30) being connected to the base of the bipolar transistor (T21) and the source of the tripping transistor (T30) being connected to the negative terminal (N).

2. Control and protection system according to Claim 1, wherein the electric load (C) is connected between the drain of the switching transistor (T10) and a positive voltage source, the load (C) not being controlled when the switching transistor (T10) is in the off state.

3. Control and protection system according to Claim 1, wherein the tripping device (30, 30') comprises a timer module (32) the input of which is connected to the output of the comparator module (31), and the tripping transistor (T30, T30') is a tripping MOS transistor (T30, T30') the gate of which is connected to the output of the timer module (32).

4. Control and protection system according to Claim 1, wherein the voltage drop element (E) comprises two diodes (D20, D21) in series, the cathodes of which are placed on the side of the negative voltage terminal (N).

5. Control and protection system according to Claim 1, wherein the voltage drop element (E) comprises a Zener diode, the cathode of which is placed on the side of the negative voltage terminal (N).

6. Automation equipment comprising a central processor unit and at least one output channel capable to control an electric load (C), the central processor unit being capable of generating a control signal (S) during the execution of a control and/or monitoring program in order to switch said output channel, the automation equipment comprising an electronic control and protection system for said output channel according to one of the preceding claims.

FIG. 1

FIG. 2

## RÉFÉRENCES CITÉES DANS LA DESCRIPTION

### Documents brevets cités dans la description

- US 4750079 A
- JP H06197445 A